Europäisches Patentamt

**European Patent Office**

Office européen des brevets

(11) Numéro de publication: **0 298 845 B1**

(12) **FASCICULE DE BREVET EUROPEEN**

(45) Date de publication de fascicule du brevet: **01.09.93**   (51) Int. Cl.⁵: **G01S 3/46**, G01S 3/72, H03H 7/25

(21) Numéro de dépôt: **88401710.4**

(22) Date de dépôt: **01.07.88**

(54) **Procédé et dispositif de protection contre un brouilleur dans une station radio comportant plusieurs antennes commutables, et leurs utilisations pour la réalisation de radiogoniomètres.**

(30) Priorité: **07.07.87 FR 8709624**

(43) Date de publication de la demande:
**11.01.89 Bulletin 89/02**

(45) Mention de la délivrance du brevet:
**01.09.93 Bulletin 93/35**

(84) Etats contractants désignés:
**DE GB IT**

(56) Documents cités:
**EP-A- 0 184 486      DE-A- 2 839 581**
**FR-A- 2 180 449      FR-A- 2 262 809**
**FR-A- 2 304 190      FR-A- 2 312 880**
**US-A- 4 220 954      US-A- 4 481 519**

**ELECTRONICS LETTERS, vol. 21, no. 20, 26 septembre 1985, pages 921-922, Hitchin, Herts, GB; T.B. VU et al.: "Minimisation of phase error in digitally controlled attenuator"**

(73) Titulaire: **THOMSON-CSF**
**51, Esplanade du Général de Gaulle**
**F-92800 Puteaux(FR)**

(72) Inventeur: **Multedo, Gilbert**
**THOMSON-CSF SCPI 19, avenue de Messine**
**F-75008 Paris(FR)**
Inventeur: **Balin, Jean-Claude**
**THOMSON-CSF SCPI 19, avenue de Messine**
**F-75008 Paris(FR)**

(74) Mandataire: **Lincot, Georges et al**
**THOMSON-CSF, SCPI, B.P. 329, 50, rue Jean-Pierre Timbaud**
**F-92402 Courbevoie Cédex (FR)**

## Description

L'invention concerne un radiogoniomètre séquentiel muni d'un dispositif de protection contre le brouillage dans une station radio comportant plusieurs antennes.

Pour garantir une qualité minimale des communications dans les systèmes de transmission radioélectrique ou encore pour des questions de coût de réalisation, il est d'usage de n'utiliser qu'un nombre limité de voies de réception qui est inférieur au nombre d'antennes appartenant à la station, en commutant, en fonction des circonstances de propagation ou encore des nécessités de traitement sur les informations reçues, les voies de réception sur les antennes les mieux appropriées. Cela vaut notamment pour les systèmes de transmission radioélectrique à diversité et pour les radiogoniomètres tels que décrits par exemple dans la demande de brevet européen EP 0184486 fonctionnant en mode séquentiel. Dans le premier cas, par exemple, la commutation est effectuée sur l'antenne la mieux adaptée aux conditions de propagation tropo ou ionosphérique et dans le deuxième cas, pour limiter les coûts de réalisation, l'unité de traitement qui est chargée du calcul de l'angle d'arrivée des ondes électromagnétiques, effectue des commutations d'aériens pour réaliser des mesures d'interférométrie sur un nombre limité de voies de réception.

La contrepartie est que ces commutations introduisent des repliements de spectres, ceux-ci étant dus à la convolution du spectre des signaux présents sur l'antenne avant filtrage par la voie de réception et du spectre du signal de commutation. Cela est d'autant plus gênant, qu'en présence d'un brouilleur, c'est-à-dire d'un émetteur dont la fréquence est calée sur une fréquence voisine de la fréquence d'exploitation de la station, une partie du spectre résultant de la convolution du signal de commutation avec le signal du brouilleur pénètre dans la bande de fréquence de réception. Dans la mesure où l'énergie du brouilleur est très supérieure à celle du signal utile, la partie de l'énergie du signal brouilleur qui est repliée dans la bande utile, peut être supérieure à celle du signal. Dans ces conditions les traitements sur les signaux reçus, sont perturbés voir même impossibles.

Pour limiter, les effets de repliement du spectre d'un brouilleur dans la bande de fréquence de réception de la station, il peut être envisagé d'effectuer pendant les commutations une atténuation du signal appliqué à l'entrée des récepteurs de la station suivant une voie de variation ayant par exemple la forme d'une courbe en cloche de Gauss comme cela est décrit par exemple dans la demande de brevet allemand 2839581.

Mais pour des chaînes de réception à grands gains compris par exemple entre 80 et 100dB, les atténuations actuellement réalisables s'avèrent encore très insuffisantes pour éviter une désensibilisation des récepteurs qui ne manque pas de se produire lorsque le niveau de brouillage récupéré sur les antennes de réception dépasse par exemple le niveau du volt. D'autre part, la réalisation d'atténuateurs performants susceptibles de répondre au problème ainsi posé et ayant une réponse du type de celle préconisée par la demande de brevet allemand précitée n'est pas non plus réalisable avec de simples diodes, car celles-ci doivent être traversées par des courants très importants, ce qui est préjudiciable à leur temps de récupération.

Le but de l'invention est de pallier les inconvénients cités.

A cet effet, l'invention a pour objet un radiogoniomètre séquentiel comprenant un réseau d'antennes génératrices de signaux haute fréquence, couplé à une unité de traitement au travers de circuits de transformation et d'aiguillage des signaux fournis par les antennes en série avec un ensemble de voies de réceptions, l'unité de traitement assurant la commande de commutation du réseau d'antennes et des circuits de transformation et d'aiguillage pour assurer le calcul de l'angle d'arrivée $\alpha$ des ondes électromagnétiques sur le réseau d'antennes par rapport à une direction géographique déterminée de l'espace dans lequel est situé le réseau d'antennes, les circuits de transformation et d'aiguillage étant formés par un ensemble de lignes à retard commutables couplées aux voies de transmission au travers d'un coupleur hybride en quadrature et d'un commutateur commandé par un signal de commande fourni par l'unité de traitement, caractérisé en ce que le commutateur comprend : un circuit atténuateur à diodes PIN placé à l'entrée de chaque voie de réception, et en ce que l'unité de traitement comprend un circuit générateur dudit signal de commande délivrant des signaux à fronts exponentiels audit circuits atténuateurs, pour réaliser une atténuation à pente douce durant un intervalle de temps déterminé entourant l'instant de commutation du signal appliqué à l'entrée des voies de réception, chaque voie de réception comprenant au moins un amplificateur à fréquence intermédiaire couplé au circuit atténuateur correspondant à travers un filtre à fréquence intermédiaire et un circuit de mémorisation du gain de chaque amplificateur à fréquence intermédiaire avant l'instant de commutation des antennes et des circuits de transformation et d'aiguillage pour empêcher le gain desdits amplificateurs de varier pendant la durée de la réponse impulsionnelle du filtre à fréquence intermédiaire.

D'autres caractéristiques et avantages de l'invention apparaîtront ci-après à l'aide de la description faite en regard des dessins annexés qui représentent :

La figure 1 le schéma synoptique général d'une station radio mettant en oeuvre un radiogoniomètre.

La figure 2 un schéma de principe d'un radiogoniomètre fonctionnant dans le mode séquentiel.

Les figures 3a et 3b, des graphes illustrant la formation de spectres de repliement dans une voie de réception.

Les figures 4a, 4b et 4c des graphes pour illustrer le fonctionnement d'une première mise en oeuvre du procédé selon l'invention.

Les figures 5a et 5b deux modes de réalisation d'atténuateurs pour masquer l'influence du spectre replié d'un brouilleur dans la bande utile.

Les figures 6a, 6b, 6c et 6d des graphes de signaux représentant le fonctionnement des atténuateurs des figures 5a et 5b.

La figure 7 un circuit de commande des atténuateurs des figures 5a et 5b.

Les figures 8a à 8d des graphes pour illustrer le fonctionnement des atténuateurs représentés aux figures 5a et 5b lorsqu'ils sont commandés par le circuit de commande représenté à la figure 7.

La figure 9 un deuxième mode de réalisation d'un circuit de commande des atténuateurs des figures 5a et 5b.

La figure 10 un mode de réalisation d'un commutateur pour permettre la permutation des voies en sortie du coupleur hybride du radiogoniomètre de la figure 2.

La figure 11 un graphe pour illustrer le fonctionnement du commutateur de la figure 10.

La figure 12 un deuxième mode de réalisation du procédé selon l'invention.

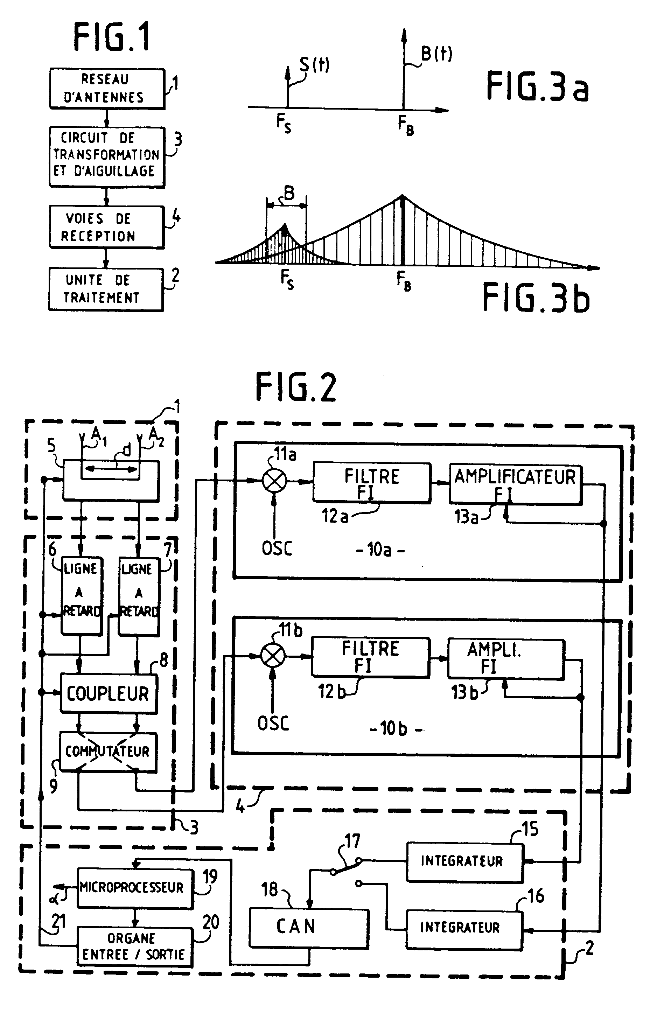

L'invention est décrite ci-après dans une application de ragoniomètrie mettant en oeuvre des radiogoniomètres fonctionnant dans le mode séquentiel, dont un exemple de réalisation détaillée, qui est repris ci-après dans les représentations des figures 1 et 2, peut être trouvé dans la demande de brevet français n° 2 573 538 déposée au nom de la Demanderesse. Le radiogoniomètre représenté suivant le schéma de principe de la figure 1 comprend un réseau 1 d'antennes qui est couplé à une unité de traitement 2 au travers de circuits 3 de transformation et d'aiguillage des signaux haute fréquence fournis par les antennes du réseau 1 et d'un ensemble de voies de réception 4. L'unité de traitement calcule l'angle d'arrivée $\alpha$ des ondes électromagnétiques par rapport à une direction cardinale fixe de l'espace géographique, celle par exemple du méridien terrestre du lieu où est situé le réseau d'antennes. Des détails de réalisation correspondants à cette architecture sont représentés à la figure 2 où les éléments homologues à ceux de la figure 1 sont repérés à l'intérieur des lignes en pointillées portant les mêmes références.

Suivant la représentation de la figure 2, le réseau d'antennes 1 est constitué par une base interférométrique 5 qui est couplée à un ensemble de voies de réception 3 au moyen de lignes à retard 6 et 7, d'un coupleur hybride à quadrature 8 et d'un commutateur 9, l'ensemble des éléments 6 à 9 constituant le circuit 3 de la figure 1. L'ensemble de voies de réception comprend deux voies composées par deux récepteurs 10a et 10b comportant chacun un dispositif changeur de fréquence 11a, respectivement 11b, un filtre de fréquence intermédiaire 12a, respectivement 12b, un amplificateur à fréquence intermédiaire 13a respectivement 13b. Une liaison de contre réaction 14a, respectivement 14b, assure la commande automatique de gain (CAG) des amplificateurs 13a et 13b. L'organe de traitement 2 est couplé aux sorties des deux récepteurs 10a et 10b et comprend deux intégrateurs 15 et 16 couplés alternativement au moyen d'un multiplieur 17 à un convertisseur analogique numérique 18. Un microprocesseur 19 est couplé à la sortie du convertisseur analogique numérique pour calculer l'angle d'arrivée $\alpha$ des ondes électromagnétiques sur les aériens 5 par rapport à la direction géographique choisie comme référence. Un organe d'entrée-sortie 20 transmet des ordres de commutation sur une ligne de commande 21 à destination d'une part, du commutateur 9 et de commutateurs, non représentés, de poids des lignes à retard 6 et 7 et des aériens 5.

En considérant, pour simplifier, que la base interférométrique 5 est composée seulement de deux antennes $A_1$ et $A_2$ distantes entre elles d'une distance d, l'écart de phase $\Delta\phi$ des signaux fournis par les deux antennes vérifie la relation :

$$\Delta\phi = \frac{2\pi d}{\lambda} \cdot \sin\alpha \qquad\qquad .1)$$

où $\lambda$ désigne la longueur d'onde des signaux.

Les signaux $S_A$ et $S_B$ obtenus aux sorties des lignes à retard 6 et 7 vérifient les relations :

$$S_A(t) = S_{(t)}.Exp\ j\ (\omega_o t + \phi_{(t)} + \omega_o \tau_A) \qquad (2)$$

$$S_B(t) = S_{(t)}.Exp\ j\ (\omega_o t + \phi_{(t)} + \omega_o \tau_B + \Delta\phi) \qquad (3)$$

dans lesquelles :

$S_{(t)}$ désigne l'amplitude et $\phi_{(t)}$ la phase propre des signaux radioélectriques reçus, $\omega_o$ la pulsation de l'onde porteuse et $\tau_A$ , $\tau_B$ les constantes de retard des lignes à retard 6 et 7.

Les signaux $S_C(t)$ et $S_D(t)$ obtenus respectivement sur les sorties du coupleur hybride 8 sont de la forme :

$$S_C(t) = \left[ S_A(t) - j\ S_B(t) \right] . \frac{1}{\sqrt{2}} \qquad (4)$$

$$et\ S_D(t) = \left[ S_B(t) - j\ S_A(t) \right] . \frac{1}{\sqrt{2}} \qquad (5)$$

Les modules de ces signaux sont :

$$|S_C(t)| = S_{(t)} \sqrt{1 - \sin \psi} \qquad (6)$$

$$et\ |S_D(t)| = S_{(t)} \sqrt{1 + \sin \psi} \qquad (7)$$

$$où\ \psi = \Delta\phi - \omega_O (\tau_A - \tau_B) \qquad (8)$$

Les sorties du coupleur hybride 8 sont alternativement reliées aux entrées des premier et second récepteurs $10_a$ et $10_b$ à un rythme fixe de période de temps T. Pendant une demi période T/2, le récepteur $10_a$ reçoit le signal $S_C(t)$ tandis que l'autre 10b reçoit le signal $S_D(t)$, l'application de ces signaux étant inversée pendant la demi-période suivante.

Si $k_1(t)$ est le gain du premier récepteur $10_a$ et $k_2(t)$ est celui du second récepteur $10_b$, les expressions des énergies $E_1$ et $E_2$ reçues par les récepteurs pendant la première demi-période s'écrivent respectivement :

$$E_1 = \int_0^{T/2} K_1(t)\ S_{(t)}\ \sqrt{1 - \sin\psi}.dt \qquad (9)$$

$$E_2 = \int_0^{T/2} K_2(t)\ S_{(t)}\ \sqrt{1 + \sin\psi}.dt \qquad (10)$$

Pendant la seconde demi-période, elles s'écrivent respectivement :

$$E_1' = \int_{T/2}^{T} K_1(t)\, S_{(t)}\, \sqrt{1+\sin\psi}\,.dt \qquad (11)$$

$$E_2' = \int_{T/2}^{T} K_2(t)\, S_{(t)}\, \sqrt{1-\sin\psi}\,.dt \qquad (12)$$

Une combinaison effectuée par le processeur 4, des quatre valeurs d'énergie définies par les relations 9 à 12, permet d'obtenir une relation qui dépend de $\phi$ et qui s'annule avec $\psi$, du type par exemple F - 1 avec :

$$F = \frac{E_2}{E_1} \times \frac{E_1'}{E_2'} = \frac{1+\sin\psi}{1-\sin\psi} \qquad (13)$$

ou encore :

$$G = \frac{E_1'\,E_2 - E_1\,E_2'}{MAX(E_1'E_2 , E_1 E_2')} = \frac{2\sin\psi}{1+|\sin\psi|} \qquad (14)$$

Une commutation des poids des lignes à retard permet en faisant varier $\tau_A$ et $\tau_B$ de ramener $\psi$ à la valeur 0 et d'en déduire $\Delta\phi$. De par la relation (8) on obtient :

$\Delta\phi = \omega_o(\tau_A - \tau_B)$.

Cependant la principale limitation technique à la mise en oeuvre du radiogoniomètre de la figure 2 est provoquée par les repliements de spectres qui sont créés par la commutation d'amplitude réalisée par la commutation des sorties du coupleur hybride en quadrature 8 et la commutation de phase réalisée par la commutation des entrées d'antennes et des poids des lignes à retard 6 et 7. Ces commutations produisent un étalement de l'énergie des signaux présents sur le réseau d'aérien 5 comme cela est représenté aux figures 3a et 3b.

Selon la représentation de la figure 3a, le spectre du signal d'entrée est limité à un signal utile d'amplitude $S_{(t)}$ et de fréquence $F_S$, il lui est adjoint un signal brouilleur d'amplitude $B_{(t)}$ et de fréquence $F_B$.

Une commutation sur les parties amont du radiogoniomètre, avant les voies de réception 10a et 10b, donne dans ces conditions un signal $E_{(t)}$ à l'entrée des voies de réception de la forme :

$E_{(t)} = C_{(t)} \times (S_{(t)} + B_t) = C_{(t)}.S_{(t)} + C_{(t)}.B_{(t)}$ (15)

où $C_{(t)}$ désigne le signal de commutation, auquel correspond dans le domaine des fréquences un spectre de la forme :

$E(f) = C(f)*S(f) + C(f)*B(f)$ (16)

où * désigne l'opérateur de convolution.

Il en résulte que, l'application du signal de commutation a pour effet d'étaler l'énergie du brouilleur, une partie du spectre C(f) * B(f) pouvant comme cela est représenté à la figure 3b pénétrer dans la bande de réception B des voies de réception 10a et 10b.

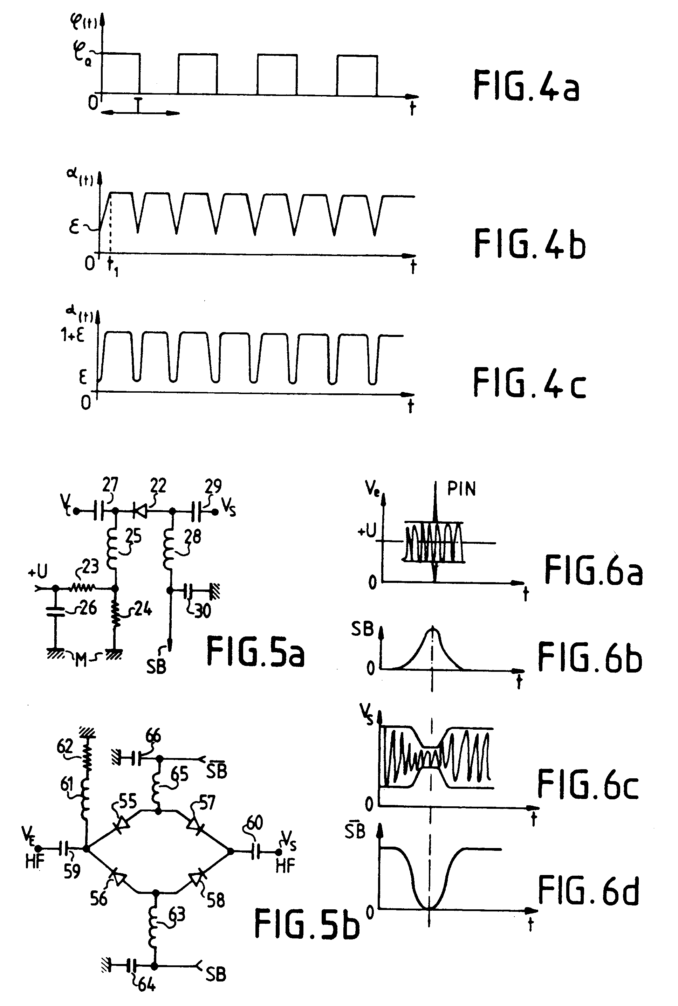

Ce phénomène peut encore être rendu plus explicite, en considérant le spectre d'une porteuse pure existant pendant une durée T et subissant une commutation de phase d'amplitude $\phi 0$ à l'instant T/2, telle que celle-ci est représentée à la figure 4a. Dans ce cas, si

$$S_{(t)} = A.\text{Exp } j\, \omega_0 t \qquad (17)$$

représente le signal de l'onde porteuse et

$$C_{(t)} = \text{Exp } j\, \phi_{(t)} \qquad (18)$$

le signal de commutation pour lequel

$\phi_{(t)} = \phi_0$ dans l'intervalle $0 \leq t \leq T/2$

$\phi_{(t)} = 0$ dans l'intervalle $T/2 < t \leq T$

le spectre $S_{(f)}$ peut être représenté par une relation de la forme :

$$S_{(f)} = 2.\cos\left(\frac{\phi_o - \pi f t}{2}\right) \frac{\sin(\pi f \frac{T}{2})}{\pi f} \text{Exp } j\,(\phi_o - \pi f T) \qquad (19)$$

Une commutation entretenue avec une périodicité T crée dans ces conditions un spectre de raies, autour de la fréquence $f_0$, d'amplitude :

$$S_n = 2.\cos\left(\frac{\phi_o - \pi_n}{2}\right) \frac{\sin(n.\frac{\pi}{2})}{n.\pi} \qquad (20)$$

Par exemple, avec $\phi_0 = \pi$, $f_0 = f_B$, $f_S - f_B = 25$ KHz et une largeur de filtre de 8 KHz, on obtient 84 raies impaires d'amplitude non nulle à l'intérieur du filtre intermédiaire 12 de réception, n étant compris entre n = 421 et n = 579. Ces raies ont pour amplitude :

$$S_n = \frac{(\sin n \frac{\pi}{2})^2}{n \frac{\pi}{2}} \qquad (21)$$

et leur énergie varie de -56,5 décibels à -59,2 décibels par rapport à l'énergie initiale du brouilleur à la fréquence $f_B$. Comme ces raies sont en phase, l'énergie totale repliée dans le filtre est égale à environ -39 décibels. Dans ces conditions les performances obtenues apparaissent peu acceptables en regard tout au moins des normes appliquées en radiocommunication, où il faut considérer qu'une protection efficace contre le rayonnement d'un canal adjacent ne peut être obtenu que pour des énergies de l'ordre de -60 à -70 décibels.

Pour pallier cet inconvénient, une première variante du procédé selon l'invention consiste à superposer à la commutation de phase une commutation d'amplitude à pente douce à l'entrée des voies de réception $10_a$ et $10_b$ en donnant au signal de commutation C(t) une forme vérifiant une relation du type :

$$C(t) = \alpha(t) \times \text{Exp } j\, \phi_{(t)} \qquad (22)$$

de la manière représentée à la figure 4b où dans l'intervalle

$$0 < t < T_1, \quad \alpha_{(t)} = \frac{1-\varepsilon}{t_1} t + \varepsilon \quad (\text{mod } k. \frac{T}{2})$$

Dans ces conditions le spectre après repliement obtenu est de la forme :

$$S_{(f)} = 2 \cos \frac{\varphi_0 - \pi f T}{2} \left[ \varepsilon \frac{\sin \pi f \frac{T}{2}}{\pi f} + \frac{1-\varepsilon}{\pi^2 f^2 t_1} . \sin \pi f t_1 . \sin \pi f (\frac{T}{2} - t_1) \right]$$

$$. \text{Exp } j ( \varphi_0 - \pi f T ) \qquad (23)$$

Le premier terme de la relation (23) représente le spectre du saut de phase précédent atténué par $\varepsilon$. Le deuxième terme limite la baisse obtenue sur le saut de phase, et il ne peut être diminué qu'en augmentant la valeur de t au prix cependant d'une perte sur la durée d'intégration du signal, dans la mesure où l'acquisition n'est pas réalisée pendant la commutation. Dans les conditions précédentes et en choisissant comme paramètres $t1 = 200$ $\mu$s, $t1/T = 10^{-2}$ et $\varepsilon = -40$dB on obtient une variation de l'énergie des raies impaires de -82 à -88 décibels. L'énergie repliée dans le filtre est alors égale à -66 décibels par rapport à l'énergie initiale du brouilleur, ce qui réalise un gain de 27 décibels par rapport à la commutation à front raide de la figure 4a.

En utilisant une commutation encore plus douce du type de celle qui est représentée à la figure 4c, où pour $0 \leq t \leq T_1$

$$\alpha_{(t)} = 1 - \cos^2 ( \pi \frac{t}{2t_1} ) + \varepsilon \quad (\text{mod } k. \frac{T}{2} ,$$

k étant un entier positif, le spectre S(f) devient pour :

$$S(f) = 2 . \cos \frac{\varphi_0 - \pi f T}{2} . P_1 . P_2 . \text{Exp } j ( \varphi_0 - \pi f T )$$

$$\text{avec } P_1 = \varepsilon . \frac{\sin \pi f . \frac{T}{2}}{\pi f}$$

$$\text{et } P_2 = \frac{\sin \pi f t_1 . \cos \pi f (t + \frac{T}{2}) - \sin \pi f . \frac{T}{2}}{\pi f (4 \pi^2 f^2 t_1^2 - 1)} \qquad (24)$$

Le premier terme est cette fois très prépondérant. L'amplitude des raies obtenues varie de -96,5 à -99,2 dB et l'énergie totale repliée dans le filtre est de -79 dB.

Des exemples de réalisation d'atténuateurs permettant d'obtenir ces résultats sont représentés aux figures 5a et 5b. L'atténuateur représenté à la figure 5a comprend une diode PIN 22 polarisée sur sa cathode à l'aide d'un diviseur potentiomètrique formé par deux résistances 23 et 24 reliées en série entre un point de potentiel +U et le potentiel de référence formé par le circuit de masse M de l'atténuateur. Le point commun aux deux résistances 23 et 24 est relié à la cathode de la diode 22 au travers d'une self de choc 25. Un condensateur 26 assure le découplage du point de potentiel + U avec le circuit de masse M. La tension $V_e$ haute fréquence supportant les "pins" de commutation à atténuer, et qui a une forme du type de celle représentée à la figure 6a est appliquée à la cathode de la diode 22 au travers d'un condensateur 27. Un signal de commande SB de la forme représenté à la figure 6b est appliqué sur l'anode de la diode 22 au travers une self de choc 28 pendant l'instant entourant l'instant de commutation. Le signal $V_S$ en sortie de l'atténuateur a l'allure représentée à la figure 6c. Il est prélevé sur l'anode de la diode 22 au travers d'un condensateur 29. Un condensateur 30 assure le découplage en haute fréquence de la tension du signal de commande SB.

Lorsque la diode 22 est bloquée par le signal SB, son impédance est assimilable à une résistance élevée de l'ordre de 10 kilohms à 100 kilohms shuntée par une faible capacité de 0,3 à 1 picofarad. Par contre, lorsque la diode 22 est passante, c'est-à-dire polarisée dans le sens direct par le signal de commande SB, son impédance devient équivalente à une résistance série de très faible valeur, comprise entre 5 à 10 ohms par exemple. Comme le courant de polarisation nécessaire dépend de la durée $\tau$ de vie des porteurs de la diode 22 comparée à la période du signal la traversant, la quantité d'énergie stockée par le courant de polarisation doit rester toujours supérieure à l'énergie alternative la traversant. Des courants de l'ordre d'une dizaine de milliampères seront généralement suffisants pour rendre la diode assimilable à une résistance d'une dizaine d'ohms. Cependant la commande de la diode 22 par le signal SB ne peut pas être réalisée à l'aide d'un signal ayant des fronts évoluant en pente douce linéaire. Ceci provient de la caractéristique de transfert de la diode 22 qui tend malgré le signal de commande à rendre le signal à commuter HF rectangulaire. Il est possible de pallier cet inconvénient en tenant compte du fait que la résistance dynamique Rd de la diode 22, dans son état passant, varie en fonction du courant qui la traverse suivant une relation de la forme :

$$Rd = \frac{KT}{q} \frac{1}{I^n} \qquad (25) \qquad \text{avec } n \simeq 0,88$$

K désigne la constante de Boltzmann, T la température absolue, q la charge de l'électron et n un coefficient. Il découle de la relation (25) que le signal SB doit être fourni par un générateur de tension à loi exponentielle pour obtenir un temps de montée linéaire du signal haute fréquence $V_S$. Le signal $S_B$ correspondant est représenté à la figure 6b.

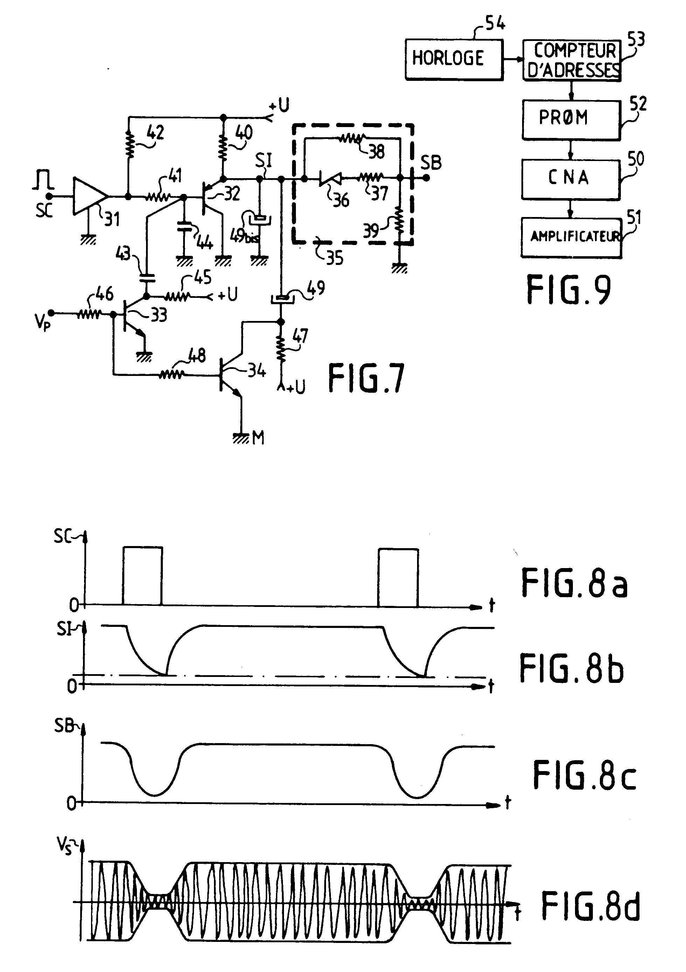

Un générateur de ce type est représenté à la figure 7. Il comprend un amplificateur inverseur 31, un ensemble de transistors 32, 33 et 34 et un réseau 35. Ce dernier qui est représenté à l'intérieur d'une ligne en pointillées est formé par une diode zener 36 reliée en série à une résistance 37, ces deux dernières étant shuntées par une résistance 38. Le point commun à la résistance 38 et à la résistance 37 est relié au circuit de masse M au moyen d'une résistance 39. Le transistor 32 est un transistor PNP qui est relié par son émetteur à une tension de polarisation + U au travers d'une résistance 40, sa base étant reliée en série en point de polarisation + U au travers de deux résistances 41 et 42. Le point commun aux deux résistances 41 et 42 est relié à la sortie de l'amplificateur inverseur 31. La base du transistor 32 est également reliée au collecteur du transistor 33 au travers d'un condensateur 43 et aux circuits de masse M au travers d'un condensateur 44. Le transistor 33 est un transistor type NPN dont le collecteur est polarisé au point de potentiel + U au travers d'une résistance 45. La base du transistor 33 est commandée à partir d'une tension de commande VP au travers d'une résistance 46. L'émetteur du transistor 33 est relié au circuit de masse M. Le transistor 34 est un transistor NPN dont le collecteur est relié au potentiel de polarisation + U au travers d'une résistance 37, son émetteur est relié au potentiel de masse et sa base est reliée à la base du transistor 33 au travers d'une résistance 48. L'émetteur du transistor 32 est relié au point commun à la diode zener 36 et à la résistance 38 et est couplé au collecteur du transistor 34 au travers un condensateur 49. Le collecteur du transistor 34 est d'autre part relié au circuit de masse M au travers d'un condensateur 49bis. Le signal de suppression SC à conformer est appliquer à l'entrée de l'amplificateur inverseur 31. Sa forme est rectangulaire et est transformé par le transistor 32 en un signal SI qui est transmis par son émetteur. Le signal SI possède la forme d'un signal à montée logarithmique et à descente exponentielle obtenue par charge et décharge des condensateurs 44 et 49bis. Le réseau 35 qui fait suite au transistor 32 transforme les montées logarithmiques du signal SI en montées sensiblement exponentielles. Les signaux SC et SI sont représentés aux figures 8a et 8b. Le signal SB qui est le signal transformé du signal SI par le réseau 35 est représenté à la figure 8c. Le signal SB appliqué sur l'entrée de commande de l'atténuateur de la figure 6a permet d'obtenir une atténuation du signal HF de la façon qui est représentée à la figure 8d.

Une variante de réalisation du générateur de tension est représentée à la figure 9. Selon cette variante, la loi exponentielle, qui est nécessaire à la commande de l'atténuateur de la figure 6a, est obtenue à partir d'un convertisseur digital analogique couplé à un amplificateur 51. Le convertisseur digital analogique 50 est relié à une mémoire morte programmable PROM 52 dans laquelle est programmée l'excitation nécessaire au convertisseur digital analogique 50. Un compteur d'adresses 53, piloté par une horloge 54, permet d'adresser les mots binaires contenus dans la mémoire PROM 52 pour exciter le convertisseur digital analogique 50. Avec un convertisseur digital analogique de 8 bits par exemple, il est ainsi possible d'obtenir 256 échelons, qui seront filtrés par l'amplificateur 51. Cette solution plus performante que la solution analogique de la figure 7 demande toutefois des précautions très importantes de filtrage, le filtrage devant être modifié à chaque changement de pente.

Enfin le mode de réalisation de l'atténuateur de la figure 5a n'est pas unique et on utilise également un circuit aiguilleur à deux voies du type de celui qui est représenté à la figure 5b mettant en oeuvre un jeu de quatre diodes PIN 55, 56, 57 et 58 montées en pont. Ce montage est utilisé dans les lignes à retard pour la commutation des poids de phase. Ici le repliement de spectre est minimisé par la montée en pente douce du signal HF au moment de la commutation, ce qui évite la génération de "pins" ou impulsions de commutation et donne une réponse spectrale conforme à la relation (23). Le signal de commande SB et son complémentaire $\overline{SB}$ sont appliqués chacun sur une extrémité d'une diagonale du pont au travers d'inductance 63 et 65 et les signaux d'entrée VE et de sortie VS sont prélevés respectivement sur l'autre extrémité de la deuxième diagonale du pont au travers 59 et 60. Les cathodes des diodes 55 et 56 sont couplées à la masse de l'atténuateur au travers d'une inductance 61 et d'une résistance 62 reliées en série. Le point d'application du signal SB est couplé à la masse au travers d'un condensateur 64 et le point d'application du signal $\overline{SB}$ est couplé à la masse au travers d'un condensateur 66.

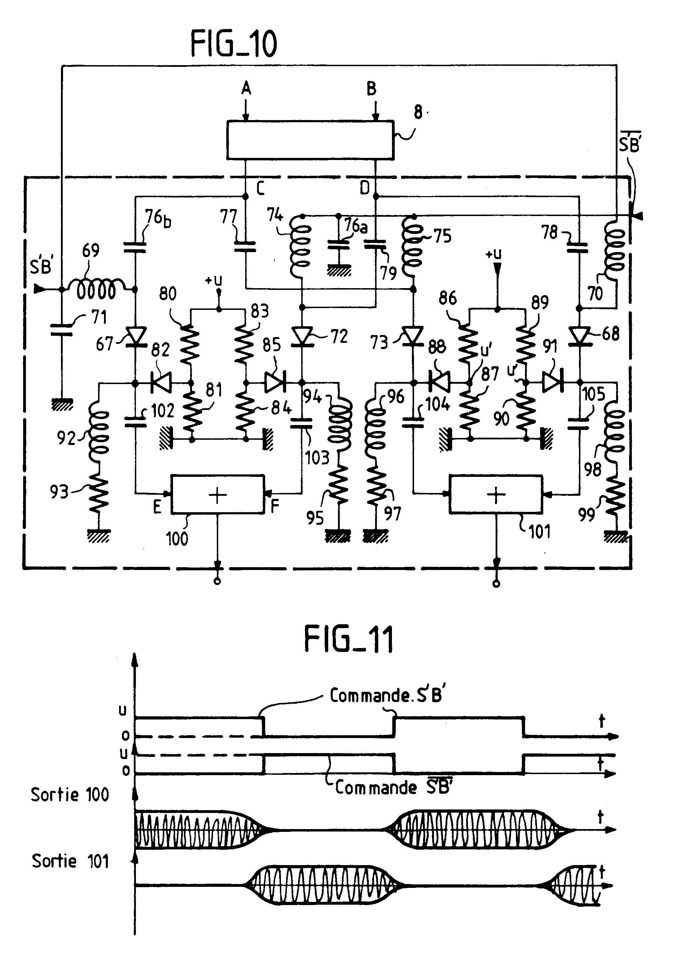

Un autre montage représenté à la figure 10 ayant des propriétés similaires à celles du circuit de la figure 5b peut encore être employée en sortie du coupleur hybride en quadrature 8 pour réaliser le commutateur 9. Comme précédemment une commutation à pente douce est mise en oeuvre pour éviter les repliements de spectre. Cette commutation a lieu sur les sorties C et D du coupleur 8 sous la commande des signaux S′ B′ et $\overline{S'B'}$ en provenance d'un générateur de signaux à fronts de montée exponentielle d'un type semblable à ceux représentés aux figures 7 et 9. Les signaux S′B′ et $\overline{S'B'}$ réalisent l'aiguillage des signaux sortant des sorties C et D du coupleur 8. Les signaux sortant du commutateur peuvent être appliqués indifféremment sur 1 ou 2 récepteurs $10_a$ ou $10_b$ pour faciliter le traitement des signaux provenant de modulation complexe. Le signal S′B′ est apopliqué sur des anodes de diodes 67 et 68 au travers respectivement d'inductances 69 et 70. Le point d'application du signal S′B′ sur les inductances 69 et 70 est couplé à la masse au travers d'un condensateur 71.

Le signal $\overline{S'B'}$ est appliqué sur les anodes de diodes à 72 et 73 au travers respectivement d'inductances 74 et 75. Un condensateur $76_a$ couple à la masse le point d'application du signal $\overline{S'B'}$ sur les inductances 74 et 75. Les anodes des diodes 67 et 73 sont d'autre part couplées à une sortie marquée C du coupleur hybride 8 au travers respectivement de condensateurs $76_b$ et 77. De façon similaire, les anodes des diodes 68 et 72 sont couplées à une sortie marquée D du coupleur hybride 8 au travers respectivement de condensateurs 78 et 79. La cathode de la diode 67 est reliée au point commun de deux résistances 80 et 81 montées en série, au trayers d'une diode 82, la diode 82 ayant son anode reliée au point commun aux deux résistances 80 et 81 et sa cathode reliée à la cathode de la diode 67. De même, la cathode de la diode 72 est reliée au point commun de deux résistances 83 et 84 montées en série, au travers d'une diode 85, la diode 85 ayant son anode reliée au point commun aux deux résistances 83 et 84 et sa cathode reliée à la cathode de la diode 72. Egalement, la cathode de la diode 73 est reliée au point commun de deux résistances 86 et 87 reliées en série au travers d'une diode 88, la diode 88 ayant son anode reliée au point commun aux deux résistances 86 et 87 et sa cathode reliée à la cathode de la diode 73. Enfin, la cathode de la diode 68 est reliée au point commun de deux résistances 89 et 90 montées en série, au travers d'une diode 91, la diode 91 ayant son anode reliée au point commun aux deux résistances 89 et 90 et sa cathode reliée à la cathode de la diode 68. Les points communs aux diodes 67, 82 ; 72, 84 ; 73, 88 ; 68, 91 sont couplés respectivement au circuit de masse M au travers d'une inductance et d'une résistance montées en série référencées respectivement 92, 93 ; 94, 95 ; 96, 97 ; 98. 99. Des circuits additionneurs 100 et 101 à deux entrées d'opérande forment les éléments de sortie du commutateur 9. Le circuit additionneur 100 a ses deux entrées d'opérande reliées respectivement d'une part, au point commun aux deux diodes 67 et 82 au travers d'un condensateur 102 et d'autre part, au point commun aux deux diodes 72 et 85 au travers d'un condensateur 103. De façon similaire, le circuit additionneur 101 a ses deux entrées d'opérande reliées respectivement d'une part, au point commun aux deux diodes 73 et 88 au travers d'un condensateur 104 et d'autre part, au point commun aux deux diodes 68 et 91 au travers d'un condensateur 105.

EP 0 298 845 B1

En se reportant aux diagrammes de la figure 11 le fonctionnement du commutateur 9 est donné ci-après en supposant que le signal S'B' est, selon un premier cycle, appliqué sur les diodes 67 et 68 avec un niveau de potentiel supérieur à un niveau de potentiel U' existant sur chaque point commun des couples de résistances 80, 81 ; 83, 84 ; 86, 87 ; 89, 90 montés en diviseur potentiométrique. Dans cette hypothèse le signal S'B' est au potentiel 0 volt. Les diodes 67 et 68 sont alors passantes et les diodes 72 et 73 sont bloquées. Les diodes 85 et 88 dont les anodes sont portées au potentiel U' sont passantes.

Au cycle suivant le signal S'B' est positif et possède un niveau de potentiel supérieur au potentiel U'. Le signal S'B' étant nul, les diodes 72 et 73 sont passantes et les diodes 67 et 68 sont bloquées. Les sorties des additionneurs 100 et 101 sont ainsi alternativement branchées sur les sorties C et D du coupleur 8. Suivant ce mode de réalisation les impédances des diodes 85 et 88 considérées dans leur sens passant et celles des diviseurs potentiomètrique qui fournissent la tension U' devront être calculées pour que l'impédance résultante permette la fermeture adaptée des entrées bloquées F et G des additionneurs 100 et 101.

Le circuit de la figure 10 n'est naturellement pas unique. Notamment un montage simplifié offrant cependant moins de souplesse, en étant moins performant, peut être réalisé en supprimant les additionneurs 100 et 101, les diodes 82, 85, 88 et 91 ainsi que les diviseurs potentiomètriques qui fournissent la tension U'. Les cathodes des diodes 67 et 72 d'une part, celles des diodes 73 et 67 d'autre part, formeront alors les sorties du commutateur 9 et seront alors reliées respectivement au circuit de masse M au travers d'une part, de l'inductance 92 et de la résistance 93 et d'autre part, de l'inductance 98 et de la résistance 99. L'avantage que l'on peut obtenir est alors un gain de 3dB sur les pertes d'insertion.

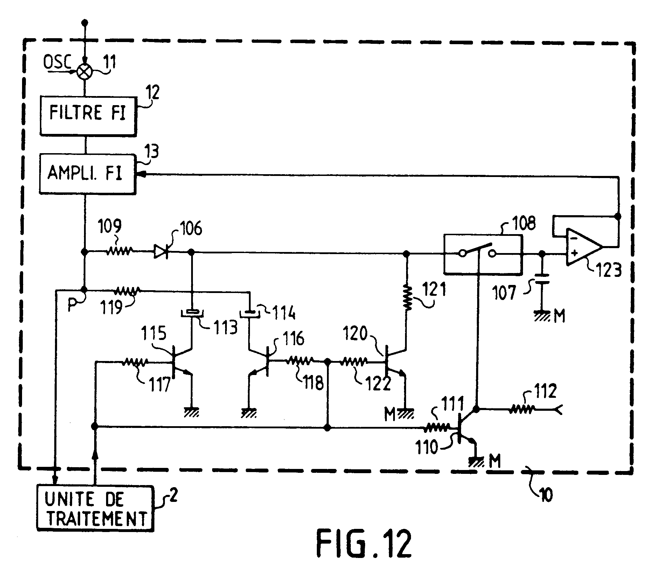

Enfin, une façon complémentaire au procédé décrit précédemment de réaliser la suppression du spectre de repliement selon l'invention est représentée à la figure 12. Contrairement au premier procédé qui dérive d'une analyse spectrale de la commutation et où l'on cherche à mettre en oeuvre une technique permettant de rendre minimal l'étalement du spectre provoqué par la commutation, le procédé qui est mis en oeuvre à la figure 12 résulte d'une approche temporelle du phénomène de repliement. On peut considérer dans ce cas, que les repliements qui sont dus au brouilleur, se manifestent par des "pins" ou impulsions de commutation qui se superposent au signal utile obtenu en sortie de l'amplificateur de fréquence intermédiaire 13 dans chaque voie de réception. Ces "pins" de commutation sont présents pendant une durée significative de réponses impulsionnelles du filtre 12 de fréquence intermédiaire de chaque voie de réception. Leur amplitude est significative des raies de repliement contenues dans le filtre 12 de chaque récepteur et leur répétition, dans le cas de sauts de phase périodiques, fait que le dispositif de commande de gain automatique 14 des récepteurs se sensibilise sur eux. Ce phénomène est d'autant plus vrai lorsque la voie de réception possède un dispositif de commande automatique de gain de constante de désensibilisation $T_d$ plus courte devant la période T de commutation et une constante de resensibilisation $T_1$ très longue devant la période de commutation. Ce phénomène peut être mis à profit, selon une deuxième variante de réalisation de l'invention, en mémorisant le gain de l'amplificateur à fréquence intermédiaire 13 avant l'instant de commutation pour l'empêcher de varier pendant la durée de la réponse impulsionnelle du filtre à fréquence intermédiaire 12 aux "pins" de commutation.

Un dispositif correspondant pouvant être mis en place dans chacune des voies de réception est représenté à la figure 12, où les éléments homologues à ceux composant chaque voie de réception de la figure 2 sont figurés avec les mêmes références et où, à la différence de la figure 2, chaque voie de réception 10 comprend en plus des éléments 11, 12 et 13, les éléments 106 à 123 qui sont disposés dans la boucle de commande de gain 14, entre la sortie et l'entrée de commande de gain de l'amplificateur à fréquence intermédiaire 13. Le niveau du signal obtenu à la sortie de l'amplificateur 13 est détecté par une diode 106 et un condensateur 107 reliés en série entre la sortie de l'amplificateur 13 et la masse M du circuit au travers d'un interrupteur de courant 108 et d'une résistance 109. La résistance 109 relie la sortie de l'amplicateur 13 à l'anode de la diode 106 et l'interrupteur 108 relie la cathode de la diode 106 à l'extrémité du condensateur 107 dont l'électrode opposée est reliée à la masse.

L'interrupteur de courant 108 est commandé par un transistor 110 polarisé par deux résistances 111 et 112. Deux condensateurs 113 et 114 relient également la cathode de la diode 106 au circuit de masse M au travers de deux interrupteurs de courant 115 et 116 formés par deux transistors commandés sur leur base par l'unité de traitement 2 au travers de deux résistances 117 et 118. Une résistance 119 relie également la cathode de la diode 67 à la sortie de l'amplificateur 13. Un interrupteur de courant 120 formé par un transistor, relie la cathode de la diode 106 au circuit de masse M au travers d'une résistance 121 pour décharger le condensateur 107 lorsque l'interrupteur de courant est passant, c'est-à-dire lorsque la base du transistor est commandée au travers d'une résistance 122 par l'unité de traitement 2. Le point commun au condensateur 107 et à l'interrupteur de courant 108 est relié à une entrée marquée " + " d'un amplificateur différentiel 123 monté en adaptateur d'impédance. Le sortie de l'amplificateur 123 est reliée à l'entrée de

10

commande de gain de l'amplificateur 17. Dans ces conditions, l'amplificateur 123 permet; avec le condensateur 107, la mémorisation de la tension de contre réaction lorsque la boucle 14 de contrôle de gain est ouverte par l'interrupteur de courant 108 et la commande sous basse impedance du gain de l'amplificateur 13. La résistance 109 et la diode 106 forment avec les condensateurs 107 et 114 la constante de temps de désensibilisation (charge des condensateurs 107 ou 114). La résistance 119 forme avec les condensateurs 107 et 114 la constante de temps de resensibilisation en permettant la décharge des condensateurs 107 ou 114 à travers la résistance 119 lorsque la diode 106 est bloquée.

Le fonctionnement du circuit est décrit ci-après dans l'hypothèse d'un état initial où les interrupteurs 108 et 120 sont fermés ce qui permet la décharge vers le circuit de masse M des condensateurs 107 et 114. Le gain de l'amplificateur 13 est alors maximal.

Le seuil de déclenchement de l'amplificateur 13 sur un signal appliqué à son entrée par la sortie du filtre à fréquence intermédiaire 12 devra cependant être réglé, par tout moyen connu, non représenté, pour éviter des saturations sur les signaux de bruits appliqués à l'entrée de l'amplificateur 13 en l'absence de signal et pour provoquer par contre la saturation de l'amplificateur 13 dès qu'un signal dépasse le seuil. L'unité de traitement 2 sélectionne la constante de temps voulue par la charge des condensateurs 107 et 114 (interrupteurs de courant 110 et 116 fermés). Pour éliminer l'action du condensateur 113 pendant la charge des condensateurs 107 et 116 l'interrupteur 115 est ouvert. L'interrupteur de courant 110 est alors ouvert et l'interrupteur 108 reste fermé. Il y a alors désensibilisation de l'amplificateur 13 pendant une période de temps déterminée par la constante de temps formée par la résistance 109 et la diode 106 qui chargent le condensateur 107 et le condensateur sélectionné 114. Dès que la charge des condensateurs est terminée, soit après un temps $t_0$ égale à environ deux fois la constante de temps de désensibilisation, il y a ouverture de l'interrupteur 108. Le gain de l'amplificateur 13 est alors stabilisé sur l'émission reçue à l'instant $t_0$ grâce à la tension mémorisée aux bornes du condensateur 107 qui ne se décharge que d'une façon extrêmement faible dans l'impédance d'entrée très élevée de l'amplificateur 123. La commutation des sorties du coupleur hybride 8, des poids de phase des lignes à retard 6 et 7 et des aériens représentés sur la figure 2 peut alors s'effectuer pour permettre la convergence du calcul de la valeur de $\Delta \psi$ vers zéro. Les "pins" de commutation restent alors sans effet sur la commande automatique de gain des amplificateurs 13 de chaque voie de réception ce qui ne provoque aucune perte de sensibilité des récepteurs.

Le même processus peut alors être réitéré à chaque nouvelle mesure de goniométrie. Cependant il est encore possible d'envisager un autre mode de fonctionnement lorsque les mesures se prolongent sur des durées relativement longues pour permettre en cas de baisse du signal à l'entrée des voies de réception notamment, d'adapter le dispositif pour que les informations d'écartométrie ne soient pas validées.

Dans ce cas, il est souhaitable que le dispositif de commande automatique du gain des amplificateurs à fréquence intermédiaire puissent suivre les variations du signal d'entrée avec des constantes de resensibilisation courtes. Pour se faire seul le condensateur 107 pourra alors être utilisé. Il suffit alors de prévoir, qu'avant toute commutation, l'unité de traitement 2 ouvre la boucle 14 et la referme au bout d'un temps légèrement supérieur à la réponse impulsionnelle du filtre 12.

## Revendications

1. Radiogoniomètre séquentiel comprenant un réseau d'antennes (5) génératrices de signaux haute fréquence, couplé à une unité de traitement (2) au travers de circuits (3) de transformation et d'aiguillage des signaux fournis par les antennes en série avec un ensemble de voies de réceptions ($10_a$, $10_b$), l'unité de traitement (2) assurant la commande de commutation du réseau d'antennes (5) et des circuits (3) de transformation et d'aiguillage pour assurer le calcul de l'angle d'arrivée $\alpha$ des ondes électromagnétiques sur le réseau d'antennes (5) par rapport à une direction géographique déterminée de l'espace dans lequel est situé le réseau d'antennes, les circuits (3) de transformation et d'aiguillage étant formés par un ensemble de lignes à retard (6, 7) commutables couplées aux voies de transmission au travers d'un coupleur hybride en quadrature (8) et d'un commutateur (9) commandé par un signal de commande (SC) fourni par l'unité de traitement (2) caractérisé en ce que le commutateur (9) comprend : un circuit atténuateur à diodes PIN (22 ; 55 ... 58 ; 67, 82, 83, 85 ; 68, 73, 88, 91) placé à l'entrée de chaque voie de réception, et en ce que l'unité de traitement (2) comprend un circuit générateur dudit signal de commande (SC) délivrant des signaux à fronts exponentiels audit circuits atténuateurs, pour réaliser une atténuation à pente douce durant un intervalle de temps déterminé entourant l'instant de commutation du signal appliqué à l'entrée des voies de réception ($10_a$, $10_b$), chaque vole de réception ($10_a$, $10_b$) comprenant au moins un amplificateur à fréquence intermédiaire (13) couplé au circuit atténuateur correspondant à travers un filtre à fréquence intermédiaire (12) et un circuit de mémorisation (107) du gain de chaque amplificateur à fréquence intermédiaire avant l'instant de commutation des antennes (1) et des circuits de transformation et d'aiguillage (3) pour empêcher le gain desdits amplificateurs (13) de varier pendant la durée de la réponse impulsionnelle du filtre à fréquence intermédiaire (12).

2. Radiogoniomètre selon la revendication 1, caractérisé en ce que le circuit générateur de signaux comporte un premier circuit (44, 32, 49bis) pour délivrer des signaux (SI) à front de monté et de descente à forme exponentielle couplé à un deuxième circuit formé par un potentiomètre à diode Zener limiteuse (36).

3. Radiogoniomètre selon la revendication 1, caractérisé en ce que le circuit générateur de signaux comporte une mémoire morte (52) couplée à un convertisseur numérique analogique (50) pour délivrer des signaux à front de montée et descente à forme exponentielle.

4. Radiogoniomètre selon l'une quelconque des revendications 1 à 3, caractérisé en ce que chaque voie de réception comprend un dispositif changeur de fréquence (11a, 11b) couplé à l'amplificateur de fréquence intermédiaire (13a, 13b) au travers d'un filtre à fréquence intermédiaire (12a, 12b).

5. Radiogoniomètre selon la revendication 4, caractérisé en ce que l'amplificateur à fréquence intermédiaire ($11_a$, $11_b$) de chaque voie de réception ($10_a$, $10_b$) comprend une boucle à commande automatique ($14_a$, $14_b$) de gain, comprenant un interrupteur de courant (108) couplé à un condensateur (107), l'interrupteur de courant étant commandé par l'unité de traitement (2) pour mémoriser le gain de l'amplificateur à fréquence intermédiaire avant l'instant de commutation des antennes et des circuits d'aiguillage.

## Claims

1. Sequential radiogoniometer comprising an antennae network (5) generating high-frequency signals, coupled to a processing unit (2) through circuits (3) for converting and routing the signals supplied by the antennae in series with a set of receiver channels ($10_a$, $10_b$), the processing unit (2) providing switchover control of the antennae network (5) and of the conversion and routing circuits (3) in order to calculate the angle of arrival $\alpha$ of the electromagnetic waves on the antennae network (5) with respect to a defined geographical direction of space in which the antennae network is situated, the conversion and routing circuits (3) being formed by a set of delay lines (6, 7) which can be switched over and are coupled to the transmission channels through a quadrature hybrid coupler (8) and a changeover switch (9) controlled by a control signal (SC) supplied by the processing unit (2), characterised in that the changeover switch (9) comprises: an attenuator circuit with PIN diodes (22; 55 ... 58; 67, 82, 83, 85; 68, 73, 88, 91) placed at the input of each receiver channel, and in that the processing unit (2) comprises a generator circuit for the said control signal (SC) delivering signals with exponential edges to the said attenuator circuits for carrying out shallow-slope attenuation during a defined time interval surrounding the instant of switchover of the signal applied to the input of the receiver channels ($10_a$, $10_b$), each receiver channel ($10_a$, $10_b$) comprising at least one intermediate frequency amplifier (13) coupled to the corresponding attenuator circuit through an intermediate frequency filter (12) and a circuit (107) for storing the gain of each intermediate frequency amplifier in memory before the instant of switchover of the antennae (1) and of the conversion and routing circuits (3) in order to prevent the gain of the said amplifiers (13) varying during the duration of the impulse response of the intermediate frequency filter (12).

2. Radiogoniometer according to Claim 1, characterised in that the signal generator circuit includes a first circuit (44, 32, 49a) for delivering signals (SI) with exponentially shaped rising and falling edges coupled to a second circuit formed by a potentiometer with a limiting Zener diode (36).

3. Radiogoniometer according to Claim 1, characterized in that the signal generator circuit includes a read-only memory (52) coupled to a digital/analog converter (50) for delivering signals with exponentially shaped rising and falling edges.

4. Radiogoniometer according to any one of Claims 1 to 3, characterized in that each receiver channel comprises a frequency changeover device (11a, 11b) coupled to the intermediate frequency amplifier (13a, 13b) through an intermediate frequency filter (12a, 12b).

12

**5.** Radiogoniometer according to Claim 4, characterized in that the intermediate frequency amplifier ($11_a$, $11_b$) of each receiver channel ($10_a$, $10_b$) comprises an automatic gain control loop ($14_a$, $14_b$) comprising a current switch (108) coupled to a capacitor (107), the current switch being controlled by the processing unit (2) to store the gain of the intermediate frequency amplifier in memory before the instant of switchover of the antennae and of the routing circuits.

## Patentansprüche

**1.** Sequentielles Funkpeilgerät mit einer Antennengruppe (5), die Hochfrequenzsignale erzeugt und an eine Verarbeitungseinheit (2) über Schaltungen (3) zum Transformieren und Verteilen der von den Antennen gelieferten Signale in Serie mit einer Gruppe von Empfangskanälen ($10_a$, $10_b$) gekoppelt ist, wobei die Verarbeitungseinheit (2) die Steuerung der Umschaltung der Antennengruppe (5) und der Schaltungen (3) zum Transformieren und Verteilen gewährleistet, damit das Berechnen des Ankunftswinkels $\alpha$ der elektromagnetischen Wellen an der Antennengruppe (5) bezüglich einer bestimmten geographischen Richtung des Raums sichergestellt wird, in dem sich die Antennengruppe befindet, wobei die Schaltungen (3) zum Transformieren und Verteilen von einer Gruppe von umschaltbaren Verzögerungsleitungen (6, 7) gebildet sind, die über einen 90°-Hybridkoppler (8) und einen mittels eines Steuersignals (SC) aus der Verarbeitungseinheit (2) gesteuerten Umschalter an die Übertragungskanäle angeschlossen sind, dadurch gekennzeichnet, daß der Umschalter (9) enthält: eine Dämpfungsschaltung mit PIN-Dioden (22; 55 ... 58; 67, 82, 83, 85; 68, 73, 88, 91), die am Eingang jedes Empfangskanals angebracht ist, und daß die Verarbeitungseinheit (2) eine Generatorschaltung für das Steuersignal (SC) enthält, die Signale mit exponientiellen Vorderflanken an die Dämpfungsschaltungen liefert, damit eine Dämpfung mit sanfter Steigung während eines bestimmten Zeitintervalls erhalten wird, die den Zeitpunkt der Umschaltung des an den Eingang der Empfangskanäle ($10_a$, $10_b$) angelegten Signals umgibt, wobei jeder Empfangskanal ($10_a$, $10_b$) wenigstens einen Zwischenfrequenzverstärker (13) enthält, der an die entsprechende Dämpfungsschaltung über einen Zwischenfrequenzfilter (12) angeschlossen ist, und eine Speicherschaltung (107) für den Verstärkungsfaktor jedes Zwischenfrequenzverstärkers vor dem Zeitpunkt der Umschaltung der Antennen (1) und der Transformations- und Verteilungsschaltung (3) enthält, damit sich der Verstärkungsfaktor, der Verstärker (13) während der Dauer der Impulsantwort des Zwischenfrequenzfilters (12) nicht ändern kann.

**2.** Funkpeilgerät nach Anspruch 1, dadurch gekennzeichnet, daß die Signalgeneratorschaltung eine erste Schaltung (44, 32, 49bis) zum Liefern von Signalen (SI) mit exponentieller Anstiegs- und Abfallflanke enthält, die an eine zweite Schaltung angeschlossen ist, die von einem Potentiometer mit Begrenzungs-Zenerdiode (36) gebildet ist.

**3.** Funkpeilgerät nach Anspruch 1, dadurch gekennzeichnet, daß die Signalgeneratorschaltung einen Festspeicher (52) enthält, der an einen Digital/Analog-Umsetzer (50) angeschlossen ist, um Signale mit exponentiellen Anstiegs- und Abflanken zu liefern.

**4.** Funkpeilgerät nach einem der Ansprüche 1 bis 3, dadurch gekennzeichnet, daß jeder Empfangskanal eine Frequenzänderungsvorrichtung (11a, 11b) enthält, die an den Zwischenfrequenzverstärker (13a, 13b) über ein Zwischenfrequenzfilter (12a, 12b) angeschlossen ist.

**5.** Funkpeilgerät nach Anspruch 4, dadurch gekennzeichnet, daß der Zwischenfrequenzverstärker (11a, 11b) jedes Empfangskanals (10a, 10b) eine Verstärkungsregelschleife (14a, 14b) enthält, die einen mit einem Kondensator (107) verbundenen Stromunterbrecher (108) aufweist, wobei der Stromunterbrecher von der Verarbeitungseinheit (2) gesteuert wird, um den Verstärkungsfaktor des Zwischenfrequenzverstärkers vor dem Zeitpunkt der Umschaltung der Antennen und der Verteilungsschaltungen zu speichern.

# FIG.1

- RESEAU D'ANTENNES — 1
- CIRCUIT DE TRANSFORMATION ET D'AIGUILLAGE — 3
- VOIES DE RECEPTION — 4
- UNITE DE TRAITEMENT — 2

# FIG.3a

$S(t)$ $F_S$   $B(t)$ $F_B$

# FIG.3b

$B$   $F_S$   $F_B$

# FIG.2

FILTRE FI 12a — AMPLIFICATEUR FI 13a — OSC — 11a — -10a-

FILTRE FI 12b — AMPLI. FI 13b — OSC — 11b — -10b-

LIGNE A RETARD 6 — LIGNE A RETARD 7 — COUPLEUR 8 — COMMUTATEUR 9

5 — $A_1$ — d — $A_2$ — 1 — 3

MICROPROCESSEUR 19 — ORGANE ENTREE / SORTIE 20 — 21

INTEGRATEUR 15 — INTEGRATEUR 16 — CAN 18 — 17 — 2

14

FIG.4a

FIG.4b

FIG.4c

FIG.5a

FIG.5b

FIG.6a

FIG.6b

FIG.6c

FIG.6d

FIG.7

FIG.9

FIG.8a

FIG.8b

FIG.8c

FIG.8d

## FIG_10

## FIG_11

FIG.12